# EUROPEAN PATENT SPECIFICATION

(11) **EP 0 240 938 B1**
(45) Date of publication and mention of the grant of the patent: **27.01.1993**
(21) Application number: 87104887.2
(22) Date of filing: 02.04.1987
(51) Int. Cl.: G03G 15/16, G03F 7/00, G03G 15/28

(54) **Image recording apparatus**
Bildaufnahmegerät
Appareil d'enregistrement d'images

(30) Priority: 03.04.1986 JP 77197/86; 20.10.1986 JP 248972/86; 20.10.1986 JP 248973/86; 20.10.1986 JP 248974/86; 20.10.1986 JP 248975/86
(43) Date of publication of application: 14.10.1987
(73) Proprietor: FUJI PHOTO FILM CO., LTD., Kanagawa-ken (JP)
(72) Inventor: Nagumo, Akihiko c/o FUJI PHOTO FILM CO., LTD, Ashigarakami-gun Kanagawa-ken (JP); Ishikawa, Minoru c/o FUJI PHOTO FILM CO., LTD, Ashigarakami-gun Kanagawa-ken (JP); Kawada, Ken c/o FUJI PHOTO FILM CO., LTD, Ashigarakami-gun Kanagawa-ken (JP)
(74) Representative: Grünecker, Kinkeldey, Stockmair & Schwanhäusser Anwaltssozietät

(56) References cited:
- EP-A- 0 091 074
- EP-A- 0 097 034
- EP-A- 0 227 041
- EP-A- 0 242 866
- EP-A- 0 261 509
- EP-A- 0 281 105
- DE-A- 3 219 769
- DE-U- 1 757 938
- GB-A- 2 201 252
- US-A- 3 044 386
- US-A- 4 104 963
- US-A- 4 118 116
- US-A- 4 624 560
- Patent Abstracts of Japan, vol. 7, no. 51 (P-179)(1196), Februar 26 1983 & JP-A-57198482
- Patent Abstracts of Japan, vol. 10, no. 52 (P-432)(2109), Februar 28 1986 & JP-A-6019558

## Description

### BACKGROUND OF THE INVENTION

The present invention broadly relates to a pressurizing type image recording apparatus in which an image carried by a photo- and pressure-sensitive material is transferred to an image receiving material as the photo-sensitive material is superposed on and pressed to the image receiving material.

More particularly, the invention is concerned with an image recording apparatus which makes use of a photo- and pressure-sensitive material having a substrate and a layer of a substance on the substrate, the substance being photo-sensitive and, not exclusively, developable by application of heat, the substance further being capable of fixing the developed image by application of a pressure, the heat-developable material after exposure and development being superposed on and pressed to an image receiving material, whereby an image is received by the image receiving material.

An image recording material employing microcapsules containing a photosensitive composition has been known. An example of such a recording material is disclosed in Japanese Patent Laid-open No. 179,836/1982. This recording material has a substrate which carries capsules made of a synthetic polymeric resin and containing a vinyl compound, a photopolymerization initiator and a coloring precursor.

In recording an image using this recording material, the material is first exposed so that the microcapsules are hardened in conformity with the form of the image. Then, as the recording material is pressed, the microcapsules which have not been hardened are ruptured so as to release the coloring agent precursor, thus forming a color image. This image recording system provides a high quality of the recorded image with a dry-type simple processing, but suffers from a disadvantage in that the photosensitivity is much smaller as compared with the system which makes use of silver halide.

Under this circumstance, the present applicant has proposed, in the specification of Japanese Patent Application No. 117089/1985, a novel recording material which has a high photosensitivity and which ensured a high quality of the recorded image with a simple dry-type process. This recording material is a photo- and pressure-sensitive heat-developable material constituted by a carrier and a layer formed on the surface of the carrier, the layer containing at least a photosensitive silver halide, reducing agent, polymerizable compound and a color image forming substance, wherein the polymerizable compound and the color image forming substance are confined in common microcapsules.

An image recording method which makes use of this photo- and pressure-sensitive heat-developable material is disclosed in the specification of Japanese Patent Application No. 121284/1985 filed by the same applicant. According to this method, the heat-developable material is first exposed so that a latent image is formed thereon in conformity with the image to be recorded. Then, the material is heated for development so that the polymerizable compound in the area where the latent image exists is polymerized to produce a polymeric compound, thus thermally setting the microcapsules. Then, the material is superposed on an image receiving material having an image receiving layer capable of receiving the color image forming substance, and is pressed to the image receiving material so that at least part of the microcapsules having no latent image is ruptured so as to transfer the color image forming substance to the image receiving material, thereby forming an image on the latter.

In order to obtain a clear image by the transfer of the heat-developed image from the photo- and pressure-sensitive heat-developable material to the image receiving material, it is essential that the heat-developable material be pressed uniformly onto the image receiving material under a given condition.

US-A-4 104 963 describes a device for the pressure fixing of a toner image at normal ambient temperatures, wherein the toner image is obtained by a direct or indirect electrostatic copying process. The known device comprises a first pressure roll of relatively large diameter rotatably supported in the stand and a second pressure roll of relatively small diameter, rotatably and displaceably supported in the stand. A plurality of pressure rollers are arranged in a series along the length dimension of the small pressure roll in an axially parallel orientation. A separate spring urges each pressure roller into contact with the second pressure roll for exerting thereon a pressing force with which the first and second rolls compress a record carrier passing through the roll gap. A setting mechanism is associated with each pressure roller for individually adjusting the pressing force exerted by each pressure roller.

A pressure-fixing device used in the field of electrophotography is known as an apparatus which is capable of uniformly pressurizing a sheet material. This device is a compact device having a pair of pressurizing rolls which are pressed to each other such that their axes form a predetermined angle α therebetween, so that the sheet material which passes through the nip between these rollers can be uniformly pressed at a high pressure. This device, however, produces a problem when it is used for the pressure-transfer of the image from the heat-developable material to the image receiving material. Namely, when two sheets, i.e., the heat-developable material and the image receiving material, are made to pass through the nip between two pressurizing rollers, these two sheets are driven in different directions because these rollers are arranged at an inclination to each other, so that two sheets tend to be offset from each other with the result that the transferred image is distorted or the sheets are wrinkled.

Another problem encountered is that there has been proposed no image recording apparatus of the kind described which is capable of performing automatically a series of operations including exposure of the heat-developable material, superposition of the heat-developable material and image receiving sheet, transfer by pressurizing and formation of the image on the image receiving material, while ensuring economical supply of the heat-developable and image receiving materials and avoiding any jamming of the materials in the apparatus, with compact design of the apparatus having no substantial projection from the apparatus body.

Still another problem encountered by the prior art is that there has been proposed no image recording apparatus of the kind described which is capable of performing automatically a series of operations including exposure of the heat-developable material, superposition of the heat-developable material and image receiving sheet, transfer by pressurizing and formation of the image on the image receiving material, while enabling an easy administration of the photosensitive material and avoiding any winding or rolling tendency of the photosensitive material, thus assuring highly precise transfer of the image and, hence, a high quality of the recorded image.

A still further problem encountered by the prior art is that there has been proposed no image recording apparatus of the kind described which is capable of performing automatically a series of operations including exposure of the heat-developable material, superposition of the heat-developable material and image receiving sheet, transfer by pressurizing and formation of the image on the image receiving material, while realizing an easy supply of the photosensitive material of desired size and suppressing the tendency of jamming of the photosensitive and image receiving materials in the apparatus with a construction which has a reduced number of portions projected from the body of the apparatus. In addition, there has been proposed no image recording apparatus which would permit a free selection of the type and size of the image receiving material, e.g., ordinary image receiving papers and transparency sheets for overhead projectors.

### SUMMARY OF THE INVENTION

Accordingly, a first object of the present invention is to provide an image recording apparatus of the type described, wherein the photo- and pressure-sensitive heat-developable material and the image receiving material, which are superposed one on the other, can be uniformly pressurized at a pressure which is easily adjustable, without being accompanied by problems such as distortion of the transferred image and wrinkling of both sheet materials.

Such an apparatus is claimed in claim 1.

A second object of the present invention is to provide a compact construction of image recording apparatus in which the portions such as those accommodating the heat-developable material and image receiving material do not project from the apparatus body, and in which the risk for the heat-developable material and the image receiving material to be jammed in the apparatus is minimized.

According to the invention, the photosensitive material and the image receiving materials can be supplied from rolls of the respective materials.

The term "photosensitive material" in this case is used to represent any material capable of transferring an exposure image to an image receiving material having an image receiving layer, by application of pressure. An example of such a material is the one which is disclosed in Japanese Patent Laid-open No. 179,836 mentioned before.

The photosensitive material may be of the type which is heat-developed or wet-developed in advance of the transfer by application of pressure. As an example of such a material, the specification of Japanese Patent Application No. 121,284 mentioned before discloses a material composed of a substrate and a layer formed on the substrate from at least a photosensitive silver halide, polymerizable compound and a color image forming substance, wherein at least the polymerizable compound and the color image forming material are charged in common capsules. When this material is used, the photosensitive material is exposed and the latent image formed by the silver halide is developed by heat-development simultaneously with the thermal setting of the polymerizable compound. Then, the pressure is applied to visualize the image.

A third object of the invention is to provide an image recording apparatus in which the photosensitive material is supplied in the form of separate sheets so that any tendency of fogging which tends to appear when the photosensitive material is rolled can be effectively suppressed and the construction of the device for supplying the photosensitive material is simplified.

It is also an object of the invention to provide an image recording apparatus in which the photosensitive material does not exhibit any winding or rolling tendency so as to suppress occurrence of jamming and to ensure a close contact with the image receiving material, thus assuring a high prevision of transfer and, hence, a high quality of the recorded image.

It is also an object of the invention to provide an image recording apparatus in which the photosensitive material is interchangeable for a variety of photosensitivity levels, sizes and other conditions.

It is also an object of the invention in which the image receiving material is supplied from a roll, so that the portions projecting from the body of the apparatus is decreased, thus allowing an easy handling of the apparatus.

According to the invention, the photosensitive material can be supplied in the form of separate sheets while the image receiving materials can be supplied from a roll of the image receiving material.

A fourth object of the present invention is to provide an image recording apparatus in which the photosensitive material and the image receiving material are supplied by devices having simple constructions.

It is also an object of the present invention to provide an image recording apparatus in which the photosensitive material and the image receiving material fed to the apparatus do not have any rolling tendency so that they are superposed in close contact with each other thus assuring a high transfer precision and, hence, high quality of the recorded image.

It is also an object of the present invention to provide an image recording apparatus in which both the photosensitive material and the image receiving material are changeable for a variety of sensitivity levels, sizes and kinds of materials, e.g., ordinary image receiving paper or transparency sheet for overhead projectors.

According to the invention, photosensitive material and the image receiving materials can be supplied, respectively, in the form of separate sheets.

A fifth object of the present invention is to provide an image recording apparatus of the kind described, wherein a series of operation including the exposure of the photosensitive material, superposing the photosensitive material on the image receiving material, and the transfer of the image by pressing is conducted automatically, wherein the photosensitive material is cut in any desired length so as to permit an easy supply of photosensitive material of a variety of sizes, while preventing jamming of the image receiving material and reducing the number of portions projecting from the body of the apparatus.

It is also an object of the invention to provide an image recording apparatus which permits an easy change of the sensitivity level, size and the type of the image receiving material such as the ordinary image receiving paper and transparent sheets for overhead projectors.

According to the invention, the photosensitive material can be supplied from a roll of the photosensitive material, while the image receiving material can be supplied in the form of separate sheets.

The above and other objects, features and advantages of the present invention will become clear from the following description when the same is read in conjunction with the accompanying drawings.

### BRIEF DESCRIPTION OF THE DRAWINGS

Fig. 1 is an illustration of an image recording device in accordance with the first embodiment of the present invention;
Fig. 2 is a perspective view of a transfer device;
Fig. 3 is an enlarged illustration of a pressurizing mechanism employing a back-up roll;
Fig. 4 is an enlarged illustration of a pressurizing mechanism employing a pair of back-up rolls;

### DESCRIPTION OF THE PREFERRED EMBODIMENTS

An image recording apparatus in accordance with the first embodiment will be described hereinunder.

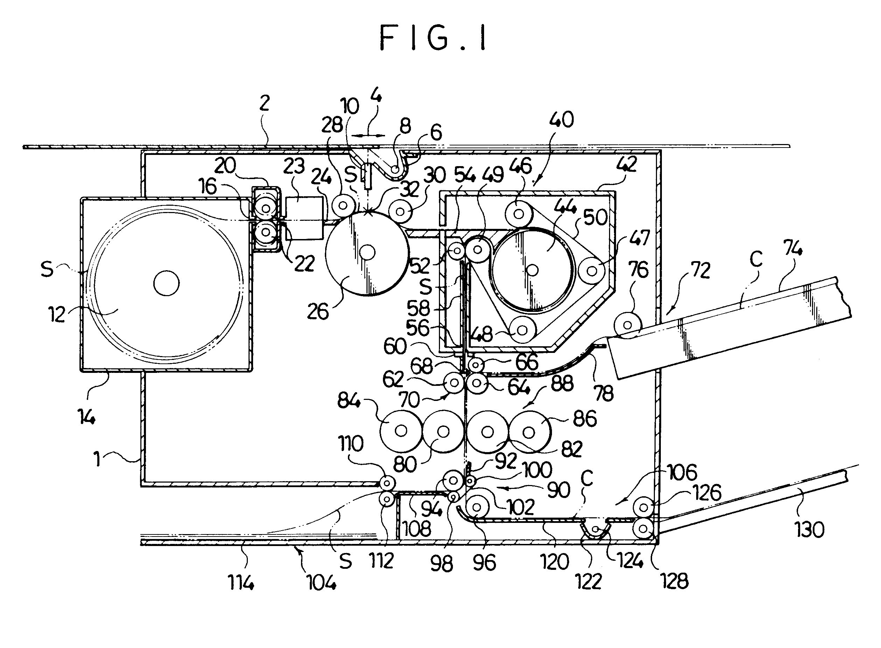

As shown in section in Fig. 1, the apparatus of the first embodiment has a housing 1 on the upper surface of which is disposed an original supporting glass plate 2 for reciprocating movement in the direction of an arrow 4. Namely, the glass plate 2 carries an original with its image side directed downwardly and moves between the position illustrated by full line and a position illustrated by an imaginary line.

An illuminating lamp 8 for illuminating an original is placed under the glass plate 2. A fiber lens array 10 is adapted for projecting the image on the original onto a photo- and pressure-sensitive heat-developable material S (referred to as "photosensitive material", hereinafter).

A catridge 14 accommodating a photosensitive roll 12 on which is wound the photosensitive material S is detachably secured to one side of the housing 1. A pair of extraction rolls 22, 22, disposed at a photosensitive material outlet 16 in the catridge 14 is received in a dark box 20 connected to a magazine. These rolls 22, 22 are adapted for extracting a predetermined length of the photosensitive material S in a predetermined time. When approached by the leading end of the photosensitive material S, the extraction rolls 22, 22 are moved away from each other as indicated by imaginary lines so as not to impede the passage of the photosensitve material S. A cutter unit 23 for cutting the photosensitive material S, as well as a guide plate 24, are disposed downstream of the dark box 20 as viewed in the direction of movement of the photosensitive material S.

A supporting roll 26 for supporting exposed photosensitive material, as well as a pair of nip rolls 28, 30 pressed thereon, are disposed downstream of the guide plate 24. The photosensitive material S guided by the guide plate 24 is held in close contact with the supporting roller 26 by the nip rollers 28 and 30. The portion of the photosensitve material between these nip rolls 28 and 30 is exposed to the image on the original through the fiber lens array 10.

A heat-developing device 40 for heat-developing an image on the exposed photosensitive material S is disposed downstream of the supporting roll 26. The heat-developing device 40 has a heat-insulating developing housing 42, a heating roller 44 disposed in the housing 42 and adapted to be heated to about 120°C, an endless belt supported by four support rolls 46, 47, 48 and 49 and wound around the heating roll 44 through an angle of 270°, and a nip roll 52 pressed onto the support roll 49.

The developing device 40 further has a guide device 54 for guiding the photosensitive material S from the support roll 26 onto the heating roll 44 and for separating the photosensitive material S from the heating roll 44 after heat-development. The developing device 40 also has a vertical guide device 58 which guides the photosensitive material S after development and fed by the support roll 49 and the nip roll 52 towards an outlet 56. A sensor 60 for sensing the leading end of the photosensitive material is provided at the outlet 56.

A superposing device 70 is disposed immediately below the outlet 56. The superposing device includes a pair of pressing rolls 62, 64, a nip roll 66 pressed onto the pressing roll 64, and a guide member 68 which guides an image receiving sheet C fed by the pressing roll 64 and the nip roll 66 towards the nip between the pressing rolls 62 and 64.

An image receiving sheet supply device 72 is disposed at one side of the superposing device 70. The image receiving sheet supply device 72 includes an image receiving sheet supply cassette 74 detachably mounted on the housing 1 so as to project therefrom, an image receiving sheet supply roll 76 for extracting the image receiving sheet C from the cassette 74, and a guide plate 78 which guides the extracted image receiving sheet C towards the nip between the pressing roll 64 and the nip roll 66. The image receiving sheet C has a width about 6 mm smaller than that of the photosensitive material S. The superposing device 70 is adapted to superpose the image receiving sheet C and the photosensitive material S such that their longitudinal axes are aligned with each other, i.e., such that the image receiving sheet C is centralized with respect to the photosensitive material in the widthwise direction.

A pressurizing image forming device, i.e., a transfer device 88 is disposed below the superposing device 70. The transfer device 88 includes a pair of pressing rolls 80, 82, and a pair of back-up rolls 84, 86 for uniformalizing the contact pressure between the pressing rolls 80 and 82.

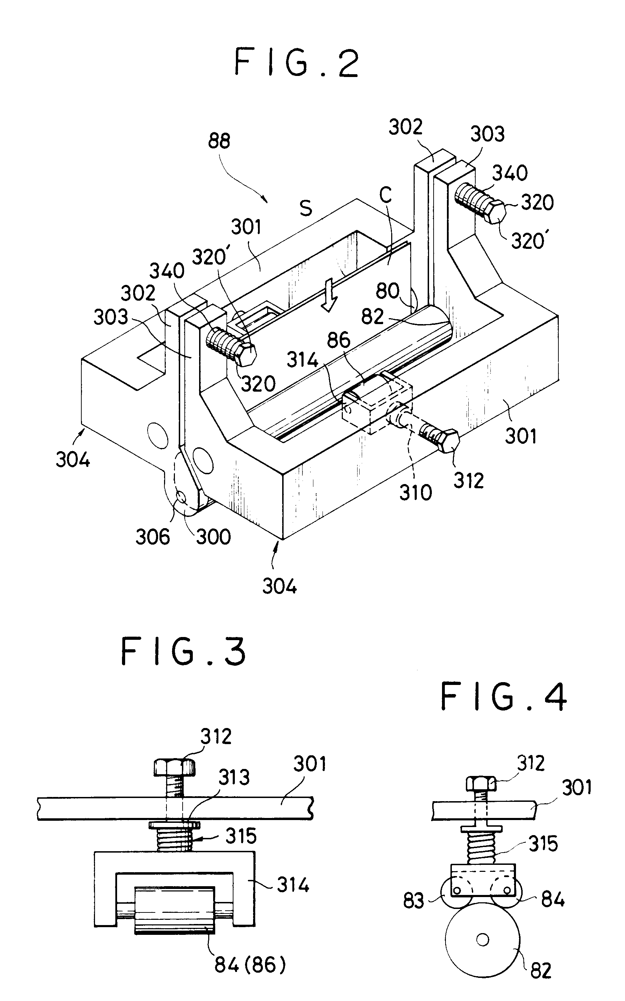

As shown in Fig. 2, the transfer device 88 includes a pair of bases 304, 304 each having a substantially U-shaped configuration and provided at its both ends with a bearing portion 300 and an adjusting arm 302 which protrude perpendicularly to the plane including the U-shape. The bases 304 are pivotally connected to each other by a pin 306.

The pressing rolls 80 and 82 are are mounted on the U-shaped portions in parallel with the axis of the pin 306. A female screw 310 is provided on the portion of the U-shaped portion extending in parallel with the axis of the pin 306. A back-up pressure adjusting screw 312 is screwed to this female screw 310. As shown in Fig. 3, a flange 313 contacting with a coiled spring 315 is provided on the end of the back-up pressure adjusting screw 312. The other end of the coiled spring 315 contacts a back-up roll support member 314. The portion of the back-up pressure adjusting screw 312 projecting beyond the flange 313 is provided with a hub (not shown) which projects into the coiled spring 315 so as to prevent the latter from moving laterally. A back-up roll 86 or 84 is supported by the back-up roll support member 314. Roll pressure adjusting screws 320 are provided on the corresponding arm portions 302 of both bases 304, for the purpose of adjusting the contact pressure between both pressing rolls 80 and 82. Each roll pressure adjusting screw 320 is screwed into a female screw formed in one 302 of the associated arm portions 302, 303 and extends through a hole formed between the other 303 of the associated arm portions 302, 303. A compression spring 340 acts between the head 320 of each roll pressure adjusting screw 320 and the adjusting arm 302.

The arrangement is such that, by rotating the roll pressure adjusting screws 320, it is possible to adjust the pressure exerted by the pressing rolls 80 and 82 on the superposed photosensitive material S and the image receiving sheet C to a desired level, e.g., 200 kg/cm². In addition, the back-up pressure acting on the axially mid portions of the pressing rolls 80 and 82 can be adjusted by rotating the back-up pressure adjusting screws 312, thus uniformalizing the pressure along the axes of both pressing rolls 80 and 82.

A sheet separating device 90 disposed under the transfer device 88 includes a guide member 92, a first feed roll 94, a second feed roll 96, and a separation belt 102 which is wound around the guide rolls 98 and 100 so as to be pressed only to the photosensitive material S at each side end of the first feed roll 94.

A photosensitive material disposal section 104 is disposed at one side of the separation device 90, while a fixing device 106 is disposed on the other side of the same. The disposal section 104 includes a guide member 108, a pair of feed rolls 110, 112, and a wasting box 114, and is adapted to send the photosensitive material S from the separation device 90 into a disposal box 114.

The fixing device 106 includes a guide member 120, an ultraviolet illuminating lamp 124 with a reflector 122, and a pair of feed rolls 126, 128. The fixing device 106 is adapted to irradiate the image receiving sheet C coming from the separation device 90 past the guide member 120 with ultraviolet ray for 5 seconds thereby fixing the image.

A delivery tray 130 for receiving the image receiving sheet C after the fixing is disposed downstream from the fixing device 106 so as to project from the housing 1.

The image recording apparatus of this embodiment further has a controller (not shown) to which are operatively connected the lighting lamp 8, cutter unit 23, original supporting glass plate 2, sensor 60 for sensing the leading end of the photosensitive material, and the superposing device 70.

The controller is adapted to control a series of operations which will be described hereinunder.

When the apparatus is in the preparatory stage for recording an image, the photosensitive material S is set such that its leading end is positioned in the vicinity of the cutter unit 23 or within the dark box 20.

Then, as the copy start button (not shown) is depressed, the photosensitive material extraction roll 22 operates to feed the photosensitive material S and the lighting lamp 8 lights up to illuminate the original before the leading end of the photosensitive material reaches a position 32.

When the leading end of the photosensitive material S has reached the position 32, the original supporting glass plate 2 is moved and the photosensitive material S is fed in synchronism therewith so that the image on the original is projected onto the photosensitive material thus exposing the latter. After the photosensitive material S is fed by a distance equal to the length of the original in the moving direction, the cutter device 23 operates to cut the photosensitive material S.

The photosensitive material S thus exposed and then cut is supplied to the heat developing device 40 where it is pressed by the endless belt 50 onto the heating roller 44 which is maintained at about 120°C, whereby the image formed by the exposure is developed. Then, the sensor 60 senses that the leading end of the photosensitive material S after development has passed the outlet 56.

Meanwhile, the image receiving sheet supply device 72 starts to operate in response to the depressing of the start button or, in synchronism with the start of exposure, so as to feed the image receiving sheet C until the leading end of the image receiving sheet C is brought into the nip between the pressing roll 64 and the nip roll 66.

The superposing device 70 then operates to superpose the image receiving sheet C and the photosensitive material S such that the image receiving sheet C is centralized with respect to the photosensitive material S in the widthwise direction while the leading end of the image receiving sheet C is aligned with that of the photosensitive material S or several millimeters ahead thereof. The device 70 then feed the superposed sheet members to the transfer device 88 where both sheet members are pressed to each other at a predetermined pressure, e.g., 150 kg/cm², so that the image is transferred to the image receiving sheet C.

After the transfer of the image, the photosensitive material S is separated from the image receiving sheet C by the belt 102 in the separation device 90 and is forwarded to the disposal section 104. Meanwhile, the image receiving sheet C carrying the transferred image is fed to the fixing device 106 where it is irradiated with ultraviolet rays for 5 seconds, whereby the image is fixed. The image receiving sheet C is then sent to the delivery tray 130 by the feed rollers 126 and 128.

The lighting lamp 8 with reflecting mirror may be of any type capable of emitting radiation rays including visible rays. For instance, a strobescopic tube, a flash lamp, a tungsten lamp, a mercury lamp, a halogen lamp such as an iodine lamp, a xenon lamp, a laser light source, a CRT light source, a plasma light source, a fluorescent lamp or a light-emitting diode can be used as the lighting lamp 8. It is also possible to use a combination of a micro-shutter array making use of an LCD (Liquid Crystal Diode) or a PLZT (lead zirconium titanate doped with lanthanum) and a linear light source or a planar light source.

In the described embodiment, the exposure of the photosensitive material S is effected by directly projecting the original image on the material S through the fiber lens array 10. This, however, is not exclusive and the fiber lens array 10 may be substituted by other suitable means such as a spherical lens. It is also possible to expose the photosensitive material S indirectly through an image electric signal, by making use of a CRT, FOT (Fiber Optic Tube), LCA (Liquid Crystal Array), electro-optical element array, a combination of a laser, modulator and a scanner, or a combination of an LED and a scanner. In such a case, it is possible to effect on the image signal various editorial processings such as gradation correction, color correction and magnification or contraction of the projected image.

In the described embodiment, the scanning of the original image is conducted by moving both the original and the photosensitive material, while stationing the optical system. This, however, is not exclusive and the scanning may be effected by moving either one of the original and the photosensitive material and the optical system.

The heating roll 44 in the heat developing device 40 also is not exclusive, and may be substituted by suitable other heating device such as a heating belt, a thermal head having an array of a heat-generating element, electric heating, or a device for applying a microwave or infrared rays. When the photosensitive material S is a specific one, the heating may be effected by eddy current which is generated by electromagnetic induction. It is even possible to use a heating bath of a liquid which is inactive to the photosensitive material, e.g., a fluoro-liquid, as the means for heating. In these cases, the heating temperature generally ranges between 80 and 200°C, preferably between 100 and 160°C.

The arrangement also may be such that the image receiving sheet is superposed to the photosensitive material S before the development and the development is effected on the photosensitive material S with the image receiving sheet C superposed thereon, followed by the pressure-transfer of the developed image, although in the described embodiment the image receiving sheet C is superposed to the photosensitive material S after the development.

It is to be understood also that the arrangement may be such that two back-up rolls 83 and 84 are pressed onto a single pressing roll 82 as shown in Fig. 4 or three or more back-up rolls are employed.

As will be understood from the foregoing description, according to the first embodiment of the invention, it is possible to transfer the image from the photosensitive material to the image receiving sheet by a compact transfer device which is capable of adjusting the pressure to be exerted during the transfer and uniformalizing the transfer pressure along the axes of the transfer pressing rolls. Namely, the pressing rolls can press the photosensitive material and the image receiving sheet uniformly with the desired pressure over the entire area to be pressed, regardless of any change in the thickness and/or width of the photosensitive material and the image receiving sheet, thus eliminating problems such as distortion of the transferred image and wrinkling of the image receiving sheet carrying the image.

In some cases, the processings such as exposure and development may not be conducted uniformly in the widthwise direction. In such a case, the lack of uniformity can be eliminated by developing such a pressure distribution in the transfer device such as to compensate for the unevenness of the processing in the widthwise direction.

## Claims

1. An image recording apparatus which employs
an image receiving material (C), and a photosensitive material (S) including microcapsules which are pressure-rupturable, unless they are light-exposed and hardened by heat, and enabling an image to be fixed by pressure,
said apparatus comprising means arranged to superpose said photosensitive material (S) and said image receiving material (C), and to press them to each other whereby an image is transferred from the former to the latter material, said means comprising
a pair of pressing rolls (80,82) for nipping said photosensitive material (S) and said image receiving material (C) therebetween;
back-up roll means (84,86) having an axial length smaller than that of said pressing rolls (80,82) and adapted for acting on at least one of said pressing rolls;
pressing roll pressing means (320) capable of independently adjusting the pressure exerted by said pressing rolls; and
back-up roll pressing means (312) capable of independently adjusting the pressure exerted by said back-up roll means on said pressing rolls.

2. An image recording apparatus according to claim 1, wherein said pair of pressing rolls (80,82) have axes parallel to each other.

3. An image recording apparatus according to claim 1, wherein said back-up roll means (84,86) includes a plurality of back-up rolls.

4. An image recording apparatus according to claim 1, wherein said photosensitive material (S) is supplied from a roll (12) of said photosensitive material, while said image receiving material (C) is supplied in the form of separate sheets.

5. An image recording apparatus according to claim 1, wherein said photosensitive material (S) and said image receiving material (C) are supplied from respective rolls (12) of these materials.

6. An image recording apparatus according to claim 1, wherein said photosensitive material (S) and said image receiving material (C) are supplied in the form of separate sheets, respectively.

7. An image recording apparatus according to claim 1, wherein said photosensitive material (S) is supplied in the form of separate sheets, while said image receiving material (C) is supplied from a roll of said image receiving material.

## Patentansprüche

1. Bildaufnahmegerät mit:
einem bildaufnehmenden Material (C), und einem photosensitiven Material (S), welches Mikrokapseln aufweist, die unter Druck zerreißbar sind, wenn sie nicht belichtet und durch Hitze gehärtet sind, und welche es ermöglichen, daß ein Bild durch Druck fixiert wird,
wobei dieses Gerät Einrichtungen beinhaltet, welche dazu angeordnet sind, um dieses photosensitive Material (S) und dieses bildaufnehmende Material (C) zu überlagern, und zusammenzupressen, wodurch ein Bild von dem ersteren zu dem letzteren Material übertragen wird, wobei diese Einrichtungen beinhalten:
ein Paar von Anpreßwalzen (80, 82), um dieses photosensitive Material (S) und dieses bildaufnehmende Material (C) dazwischen zu pressen;
Stützwalzen (84, 86), welche eine axiale Länge aufweisen, die geringer ist, als die der Preßwalzen (80, 82), und welche dafür vorgesehen sind, auf zumindest eine der Preßwalzen zu wirken;
Preßwalzen-Preßeinrichtungen (320), welche dafür eingerichtet sind, den Druck, der durch diese Preßwalzen ausgeübt wird, unabhängig einzustellen;
Stützwalzen-Preßeinrichtungen (312), welche dafür eingerichtet sind, den Druck, welcher durch diese Stützwalzen-Einrichtungen auf diese Preßwalzen ausgeübt wird, unabhängig einzustellen.

2. Bildaufnahmegerät gemäß Anspruch 1, wobei dieses Paar von Preßwalzen (80, 82) parallele Achsen aufweist.

3. Bildaufnahmegerät gemäß Anspruch 1, wobei diese Stützwalzen-Einrichtungen (84, 86) eine Vielzahl von Stützwalzen beinhalten.

4. Bildaufnahmegerät gemäß Anspruch 1, wobei dieses photosensitive Material (S) von einer Rolle (12) von diesem photosensitiven Material zugeführt wird, während dieses bildaufnehmende Material (C) in Form von einzelnen Blättern zugeführt wird.

5. Bildaufnahmegerät gemäß Anspruch 1, wobei dieses photosensitive Material (S) und dieses bildaufnehmende Material (C) von entsprechenden Rollen (12) von diesen Materialien zugeführt werden.

6. Bildaufnahmegerät gemäß Anspruch 1, wobei dieses photosensitive Material (S) und dieses bildaufnehmende Material (C) jeweils in der Form von separaten Blättern zugeführt wird.

7. Bildaufnahmegerät gemäß Anspruch 1, wobei dieses photosensitive Material (S) in der Form von einzelnen Blättern zugeführt wird, während dieses bildaufnehmende Material (C) von einer Rolle von diesem Bildaufnahmematerial zugeführt wird.

## Revendications

1. Appareil d'enregistrement d'image, qui emploie :
un matériau (C) de réception d'image, et un matériau photosensible (S) comportant des microcapsules qui peuvent se rompre sous l'effet de la pression, sauf si elles ont été exposées à la lumière et durcies par la chaleur, et permettant le fixage d'une image par application de pression,
ledit appareil comprenant un moyen conçu pour superposer l'un à l'autre ledit matériau photosensible (S) et ledit matériau de réception d'image (C), et les presser l'un contre l'autre de manière qu'une image soit transférée du premier matériau au deuxième matériau, ledit moyen comprenant :
une paire de cylindres de pression (80, 82) destinés à "pincer" ledit matériau photosensible (S) et ledit matériau de réception d'image (C) entre eux;
un moyen (84,86) formant un cylindre d'appui, dont la longueur axiale est plus petite que celle desdits rouleaux de pression (80, 82) et qui est conçu pour exercer son action sur au moins un desdits cylindres de pression ;
un moyen (320) d'application de pression aux cylindres de pression, qui est en mesure d'ajuster de façon indépendante la pression exercée par lesdits cylindres de pression ; et
un moyen d'application de pression au cylindre d'appui (312), qui est en mesure d'ajuster de façon indépendante la pression exercée par ledit moyen formant un cylindre d'appui sur lesdits cylindres de pression.

2. Appareil d'enregistrement d'image selon la revendication 1, où les axes desdits deux cylindres de pression (80, 82) sont parallèles entre eux.

3. Appareil d'enregistrement d'image selon la revendication 1, où ledit moyen (84, 86) formant un cylindre d'appui comporte plusieurs cylindres d'appui.

4. Appareil d'enregistrement d'image selon la revendication 1, où ledit matériau photosensible (S) est fourni à partir d'un rouleau (12) dudit matériau photosensible, tandis que ledit matériau de réception d'image (C) est fourni sous la forme de feuilles séparées.

5. Appareil d'enregistrement d'image selon la revendication 1, où ledit matériau photosensible (S) et ledit matériau de réception d'image (C) sont fournis à partir de rouleaux respectifs (12) de ces matériaux.

6. Appareil d'enregistrement d'image selon la revendication 1, où ledit matériau photosensible (S) et ledit matériau de réception d'image (C) sont respectivement fournis sous la forme de feuilles séparées.

7. Appareil d'enregistrement d'image selon la revendication 1, où ledit matériau photosensible (S) est fourni sous la forme de feuilles séparées, tandis que ledit matériau de réception d'image (C) est fourni à partir d'un rouleau dudit matériau de réception d'image.
